# EUROPEAN PATENT APPLICATION

(11) **EP 2 824 691 A1**
(43) Date of publication of application: **14.01.2015**
(21) Application number: 14176107.2
(22) Date of filing: 08.07.2014
(51) Int. Cl.: H01J 37/34, C23C 14/16, C23C 14/18, C23C 14/35, C23C 14/06, H01F 10/14, H01F 41/18

(54) **Deposition of thick magnetizable films for magnetic devices**

(30) Priority: 08.07.2013 US 201361843571 P
(71) Applicant: Veeco Instruments, Inc., Plainview, NY 11803 (US)
(72) Inventor: Cerio, Frank M., Jr., Albany, NY 12203 (US); Hieronymi, Robert, Monroe, NY 10950 (US)
(74) Representative: Findlay, Alice Rosemary

(57) **Abstract**

A PVD chamber for growing a magnetic film of NiFe alloy at a growth rate of greater than 200 nm/minute produces a film exhibiting magnetic skew of less than plus or minus 2 degrees, magnetic dispersion of less than plus or minus 2 degrees, DR/R of greater than 2 percent and film stress of less than 50 MPa. NiFe alloy is sputtered at a distance of 2 to 4 inches, DC power of 50 Watts to 9 kilowats and pressure of 3 to 8 milliTorr. The chamber uses a unique field shaping magnetron having magnets arranged in outer and inner rings extending about a periphery of the magnetron except in two radially opposed regions in which the inner and outer rings diverge substantially toward a central axis of the magnetron.

## Description

The present invention generally relates to thin film magnetic devices such as transducers, sensors, recording heads, and random access memory, and methods of making the same.

Thin film deposition techniques are used to form thin films on underlying substrates. Several types of thin film deposition techniques exist, including physical vapor deposition, chemical vapor deposition, atomic layer deposition, and others.

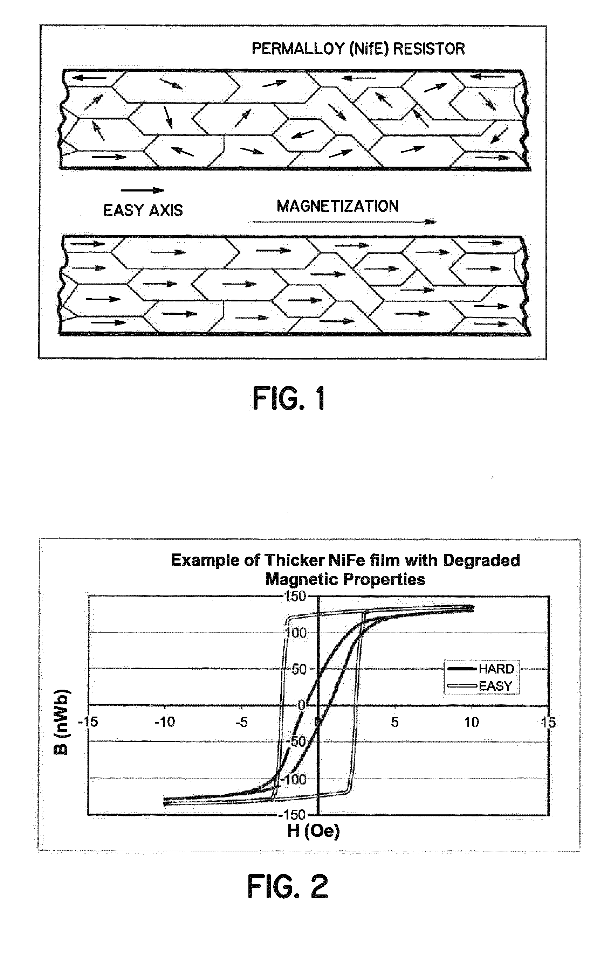

Thin film deposition techniques are used in the manufacture of magnetic devices, by the deposition of thin films of magnetic material on a substrate. These thin films can then be used to make a wide variety of devices, including magnetic transducers/sensors (AMR), magnetic recording (GMR) and magnetic random access memory (MRAM). To achieve good device sensitivity with negligible hysteresis, the magnetic domains within the NiFe film have to be aligned in the same direction. This alignment is achieved by depositing the film in a strong magnetic field that aligns the deposited particles to a so-called "Easy Axis" or preferred orientation of the magnetization (M), which is typically in the plane of the film, as seen in Fig. 1. With a uniform and predictable magnetic orientation, good device performance can be achieved.

Permalloy (Ni81 Fe19) is a ferromagnetic Ni-Fe alloy with high magnetic permeability, high magnetic saturation and low coercivity that has been used often for thin films. However, films of permalloy are susceptible to circulating induced currents or eddy currents, particularly at greater film thickness. These currents lead to undesirable losses, and their incidence is proportional to the square of the core thickness. High frequency sensors, which are increasingly in demand, require a thicker conducting core, which has proven difficult to accomplish using Permalloy due to the increasing induction of eddy currents. The result has been degraded magnetic properties, illustrated in Fig.2, in the form of a wider hysteresis and lower achieved magnetic flux density in the material in the easy direction.

One known approach to reducing eddy currents in magnetic material, is to laminate the magnetic material with insulating layers. This technique has been used in high power transformers as well as in micromachined magnetic cores and inductors.

In one aspect, the present invention provides a method for growing a magnetic film of NiFe alloy at a growth rate of greater than 200 nm/minute, which produces a film exhibiting magnetic skew of less than plus or minus 2 degrees and/or magnetic dispersion of less than plus or minus 2 degrees and/or DR/R of greater than 2 percent and/or film stress of less than 50 MPa. The method comprises sputtering NiFe alloy from a target at a distance of 2 to 4 inches, at a DC power in the range of 50 Watts to 9 kiloWats and pressure in the range of 3 to 8 milliTorr.

In another aspect, a sputtering tool has a unique field shaping magnetron having magnets arranged in outer and inner rings, the outer ring magnets having North poles facing the electrode and sputtering target assembly and the inner ring having South poles facing the electrode and sputtering target assembly, wherein the inner and outer rings extend about a periphery of the magnetron except in two radially opposed regions in which the radially opposed regions the inner and outer rings diverge substantially toward a central axis of the magnetron. The magnetron develops a field uniformity sufficient for rapid growth of high uniformity, low stress films by the appropriate adjustment of process conditions as described herein.

The invention will now be further described by way of example with reference to the accompanying drawings, in which:
Fig. 1 is a schematic illustration of the magnetic domains of a Permalloy (NiFe) thin film showing the orientation of domains before and after magnetization in the easy (plane of film) direction;
Fig. 2 is a B-H plot of a thick Permalloy film grown according to the prior art, showing magnetic degradation in the form of increased hysteresis and nonlinearity in the easy direction;
Fig. 3 is an illustration of a physical vapor deposition (PVD) tool used in accordance with principles of the present invention in making an improved Permalloy film;
Fig. 4A is a plan view of the layout of the magnetron used in the PVD tool of Fig. 3, showing the novel configuration of magnetic poles;
Fig. 4B is a plot of the dispersion of the magnetic flux density (B field) at the surface of the substrate carrier of the PVD tool of Fig. 3;
Fig. 5A is an illustration of a basic stacking unit for creating films up to 10 µm, using Permalloy layers of 335 nm thickness and AlN layers of 10 nm thickness; Fig. 5B is an illustration of a 1.34 µm film including four such Permalloy layers of 335 nm thickness; and Fig. 5C is an illustration of a 1.34 µm film including two Permalloy layers of 670 nm thickness.
Fig. 6A shows the B-H Loop characteristics for the easy and hard axis of a thin Permalloy film made in accordance with the present invention, showing a narrow hysteresis loop and relatively higher magnetic flux density achieved in the easy axis, and Fig. 6B shows the DR/R plot for this Permalloy film;
Fig. 7 illustrates the B-H loop for a laminated thick film formed as shown in Fig. 5B;
Fig. 8 is a plot showing the measured film stress of a laminated thick film formed as shown in Fig. 5B, as a function of applied bias power;
Fig. 9 illustrates the B-H loop for a laminated thick film formed as shown in Fig. 5C; and
Fig. 10 is an SEM micrograph of a Permalloy laminate film generally formed according to Fig. 5B, showing the distinctive alternating magnetically oriented film and insulating layers.

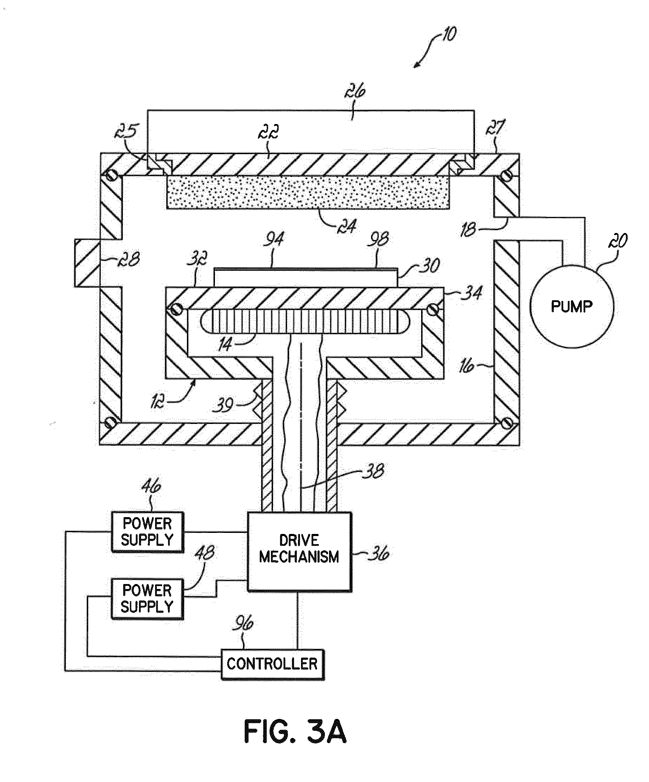

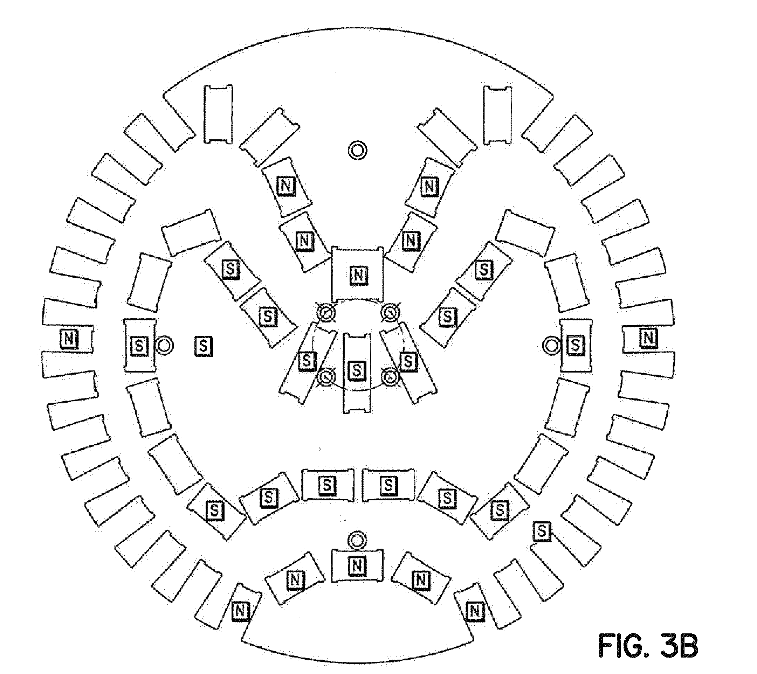

Referring first to FIG. 3, a physical vapor deposition (PVD) sputtering system is shown. The PVD sputtering system, generally designated by reference numeral 10, is used to produce thin films of material on a substrate according to the concepts of the present invention. Details of the chamber and magnet structure for PVD sputtering is shown in U.S Patents 6,126,790 and 6,106,682. It will be appreciated however, that the PVD sputtering system 10 is merely exemplary, however, and that the teachings contained herein can also be applied to other PVD systems.

Referring to FIG. 3, thin-film sputtering apparatus 10 includes a chuck assembly 12 incorporating an electromagnet 14. Other features include a low-pressure processing chamber 16 having an outlet port 18 connected to a vacuum pump 20 for evacuating air and plasma process gases from the chamber 16. Opposite to the chuck assembly 12 is an electrode or backing plate 22 supporting a target 24 of Permalloy (Ni81 Fe19), although principles of the present invention may be applied to the use of other soft or hard magnetic materials, such as ferromagnetic alloys NiFe, FeTaN, FeAlN, FeCrHfN, NeFeRe, Sendust, or Copt.

A magnetron 26 provides electrical energy and regulates erosion of the target 24 during sputtering operations. The magnetron source 26 may be a DC magnetron or RF magnetron PVD energy source. Moreover, a non-magnetron energy source, such as RD diode, may also be used. The backing plate 22 receives the electrical power for target sputtering and is electrically isolated from a vacuum lid 27 using an insulating ring 25. An access valve 28 provides a resealable opening for moving a substrate 30 into and out of the chamber 16 (e.g., using a central water handler in a cluster tool).

The substrate 30 is supported on a mounting surface 32 of the chuck assembly 12. The mounting surface 32 is part of a mounting table 34 that can be arranged to regulate substrate temperature. For example, the table 34 can incorporate a heating unit, a cooling unit, or both. Heat exchanges between the table 34 and the substrate 30 can be facilitated by a heat-transfer gas. More detailed examples of chuck assemblies for regulating substrate temperature are found in U.S. patent 6,138,745. The chuck assembly 12 may also provide a capability for electrical biasing such as RF biasing of the substrate.

A drive mechanism 36 translates the chuck assembly 12 along an axis 38 toward or away from the target 24 in order to control the substrate-to-target spacing. Bellows 39 seal the chuck assembly 12 to the processing chamber 16 to accommodate a range of chuck assembly translation heights and to atmospherically isolate the components of the chuck assembly 12, including electromagnet 14, from the evacuated space of the processing chamber 16. Power supplies 46 and 48 operated by a controller 96 implement the desired positioning of the substrate and magnetic drive.

Sputtering and annealing operations lay down and treating thin-film magnetic materials 98 on the substrate surface 94. Processes for laying down films on substrates are well known. U.S. Pat. No. 5,630,916 describes a plate-shaped electromagnet incorporated into a chuck assembly for magnetically orienting such thin magnetic films.

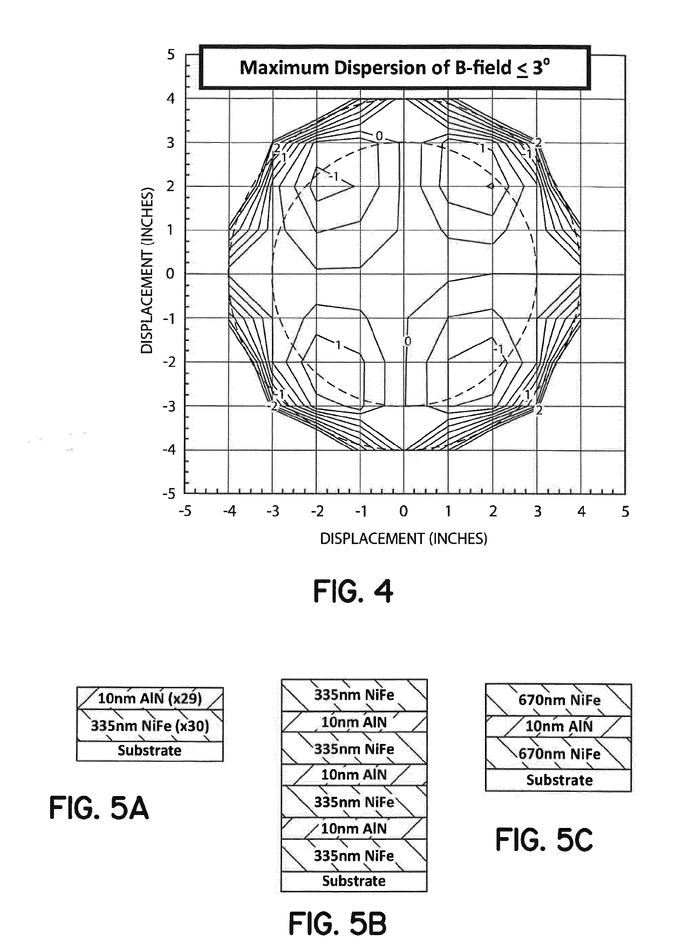

Fig. 4A shows the layout of magnets in the magnetron and Fig. 4B shows the dispersion of the B field achieved by this configuration. As seen in Fig. 4A, the magnetron includes an outer ring of magnets arranged with North poles facing the target; the outer ring diverges toward the central axis of the magnetron in two radially opposed regions, each region being approximately sixty degrees of radial width about the magnetron. In the first diverging radial region the distance of the outer ring from the central axis reduces by approximately one-fourth, and in the second, opposed, radial region the distance of the outer ring from the central axis reduces by approximately three-fourths. The magnetron also includes an inner ring of magnets arranged with South poles facing the target; the inner ring diverges toward the central axis of the magnetron in first and second opposed radial regions which correspond to the regions in which the outer ring diverges. In the first radial region the distance of the inner ring from the central axis reduces by about one third, and in the second, opposed, radial region, the outer ring diverges inward substantially to the central axis.

With this configuration, magnetically aligned NiFe is deposited at rates >500nm/min without a prior target conditioning step, leading to a process times of less than 40sec / laminate for a 335nm thick film. Wafer temperature is controlled under 150C for the entire process to preserve the magnetic film properties. Stress is maintained under 100MPa (tensile).

With an appropriate tool configuration, throughputs of less than 25min/wafer can be achieved for a 333nm NiFe / 10nm alternating insulating film (like AlN) for a total stack of ∼ 10000nm.

The parameters of tool configuration and the range, nominal, low rate and high rate settings for each parameter are set forth in the following table:

| | **DC Power** | **RF Power** | **Pressure** | **EM Current** | **EM Frequency** | **EM duty Cycle** | **Source to Substrate Spacing** |
|---|---|---|---|---|---|---|---|
| **Range** | 50W-10kW | 0-800W | 3-8mT | 0-15A | 0.1 1 Hz | 30-60% | 2-4" |
| **Nominal** | | | | | | | |
| **Low Rate Process** | 1 kW | 0-200W | 3mT | 5-15A | 0.25 | 50 | 2-4" |
| **High Rate process** | 9kW | 400-700W | 8mT | 15A | 0.25 | 50 | 2-4" |

The performance of the chamber in the growth of Permalloy films, Permalloy laminates, AlN insulating layers, and TaN insulating layers, has been measured as follows:

| | **NiFe Thin Film** | **NiFe Thick Laminate** | **AlN Insulator** | **TaN Insulator** |
|---|---|---|---|---|
| Rate (nm/min) | 40-100 | -500 | <10 | <20 |
| Uniformity (1σ) | 1.5 | 2.0 | 1.0 | 3 |
| Repeatability (1σ) | <1 | <1 | <1 | <3 |
| Resistivity (µΩcm) | <25 | <25 | - | 3000-5000 |
| Magnetics | | | | |
| Skew | <+/- 2° | <+/- 2° | | |
| Dispersion | <+/- 2° | <+/- 2° | | |
| DR/R | >2% | >2% | | |
| Temperature (°C) | <100 | <100 | <100 | <100 |
| Hardware | | | | |
| Stress (MPa) | 0±200 | 0±200 | 0±200 | <-2000 |
| Chuck Type | Std | Actively Cooled | Std | Actively Cooled |
| Magnetron | Std | High Rate | Reactive | Reactive |

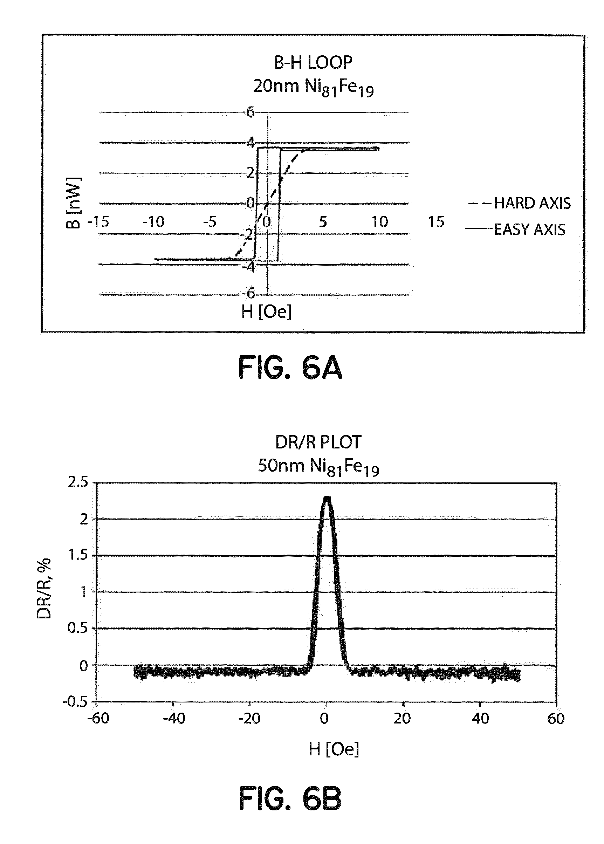

The chamber shown in Fig. 3 may be used to grow films of varying thickness, as seen in Fig. 5A, 5B and 5C. Specifically, the PVD sputtering process may be used to deposit thin Ni81Fe19 (Permalloy) films for magnetic sensor applications, as explained in the first column of the above table. Figs. 6A and 6B show the B-H Loop characteristics and the DR/R plot for a thin NiFe film deposited in this manner, which show good characteristics (narrow hysteresis loop, high saturation flux density).

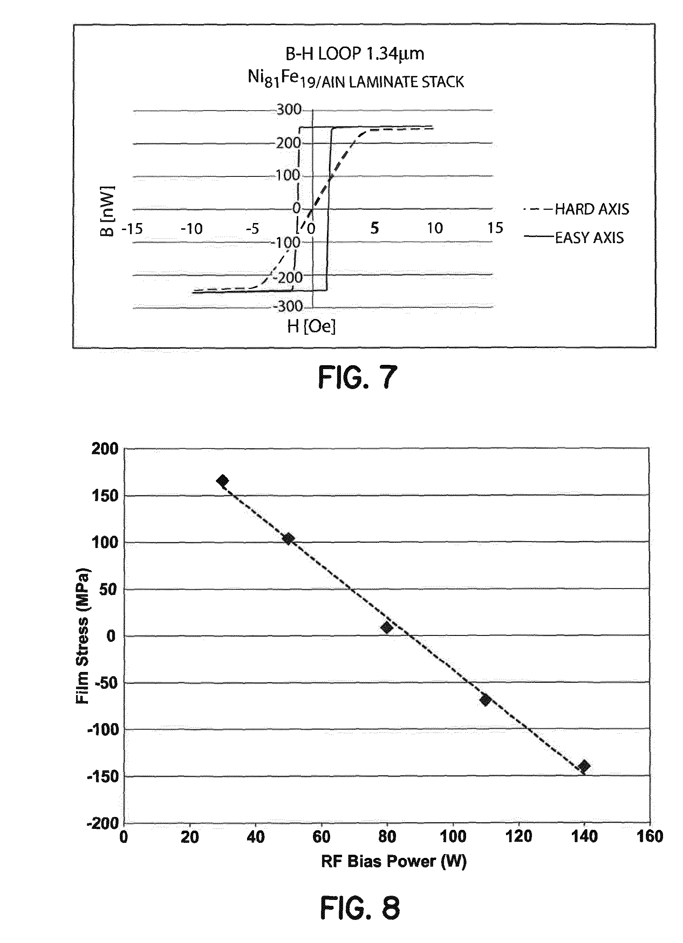

Up to a total 15000nm of NiFe has been deposited by alternating between the NiFe layer between 300-750nm and an insulating layer between 5-10nm to form a laminate structure, as shown in the second and third columns of the above table. Fig. 5A illustrates a standard build unit of alternating 335 nm NiFe and 10 nm AlN layers; Fig. 5B illustrates this standard build unit repeated four times to create a 1.34 micron film. Figure 7 illustrates the B-H loop and achieved magnetic flux density values for a 1.34µm laminate film having the structure shown in Fig. 5B.

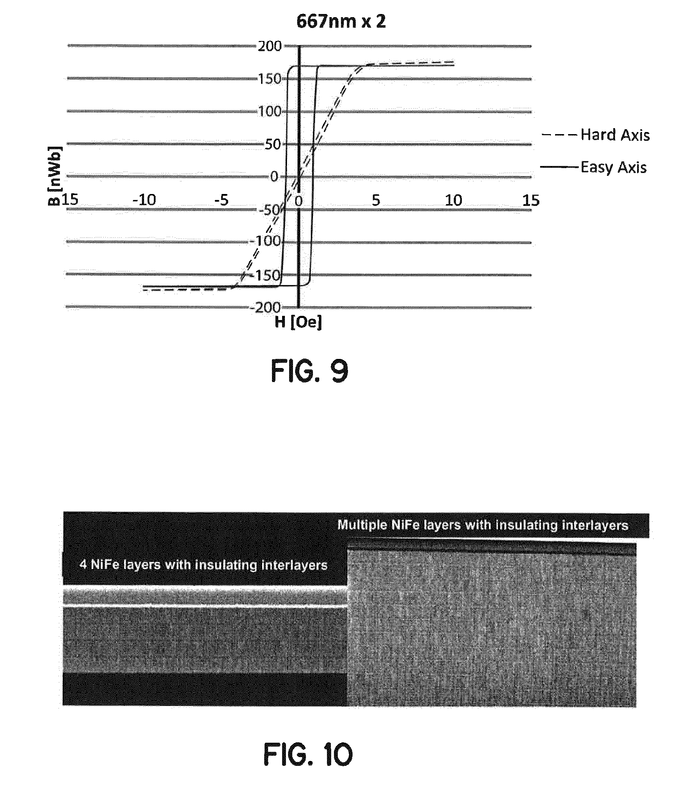

Thicker Permalloy films may also be deposited, subject to possible reduction of magnetic properties. As one example, Fig. 5C shows a 1.34 micron stack formed from two 670 nm Permalloy layers and one 10 nm AlN layer. For films of approximately 1µm and above, NiFe is deposited in a laminate form with NiFe layers interspersed with an insulating layer such as AlN. The laminate structure ensures that the magnetic orientation is fixed in the plane of the film and inhibits the formation of "stripe domains" that would drive the magnetic orientation perpendicular to the film plane, and the laminate structure also reduces the opportunity for eddy currents. Figure 9 illustrates the B-H loop and achieved magnetic flux density values for a 1.34µm laminate film having the structure shown in Fig. 5C.

The insulating layer may be formed of AlN or alternatively of TaN, with similar results, as shown in the last column of the above table.

Thicker NiFe films require a high deposition rate for throughput optimization. This high rate generates high temperatures at the substrate and therefore good substrate cooling is critical to minimize degradation of magnetic properties. In addition, the magnetron must be of an optimum design to enable, high rate sputtering with uniform deposition without disrupting the magnetic orientation of the film.

The laminated process described herein permits control of film stress, which is critical, particularly for thicker films for adhesion reasons and to minimize substrate bow which could interfere with the device performance, as well as to reduce magnetrorestrictive effects. Figure 8 shows how the film stress can easily be tuned from tensile to compressive through the application of RF generated bias on the substrate during deposition. Near zero film stress is achieved at approximately 80 Watts of RF Bias power.

The SEM micrograph of a NiFe laminate film in Figure 9 clearly shows the distinctive alternating magnetically oriented film and the insulating layer.

While the present invention has been illustrated by the description of specific embodiments thereof, and while the embodiments have been described in considerable detail, additional advantages and modifications will readily appear to those skilled in the art. The various features discussed herein may be used alone or in any combination.

## Claims

1. A method of growing a magnetic film of NiFe alloy at a growth rate of greater than 200 nm/minute using a sputtering process, the film exhibiting one or more of:
a. magnetic skew of less than plus or minus 2 degrees;
b. magnetic dispersion of less than plus or minus 2 degrees;
c. DR/R of greater than 2 percent; and
d. film stress of less than 50 MPa
the method comprising sputtering from a NiFe alloy target spaced from a target at a distance of 2 to 4 inches, at a DC power in the range of 50 Watts to 9 kiloWats and pressure in the range of 3 to 8 milliTorr.

2. The method of claim 1 further comprising sputtering at an RF power in the range of 0 to 700 Watts.

3. The method of claim 2 further comprising sputtering at an RF power in the range of 400 to 700 Watts.

4. The method of either claim 2 or claim 3 further comprising adjusting the applied RF power to a nominal value of approximately 80 Watts selected to reduce film stress.

5. The method of any preceding claim further comprising sputtering while controlling an electromagnet duty cycle to between 30 and 50 percent.

6. The method of any preceding claim further comprising sputtering while controlling an electromagnet current to between 5 and 15 Amps.

7. The method of any preceding claim further comprising sputtering while controlling an electromagnet frequency to approximately 0.25 Hz.

8. A sputtering tool for growing a magnetic film of NiFe alloy at a growth rate of greater than 200 nm/minute using a sputtering process, the sputtering tool comprising:
a. a vacuum chamber;
b. a vacuum pump for evacuating the chamber;
c. a chuck supporting a substrate to be sputtered;
d. an electrode and sputtering target assembly comprising material to be sputtered to the substrate;
e. a magnetron positioned on a side of the electrode and sputtering target assembly opposite to the chuck; and
f. a source of electrical power for causing sputtering from the target;
wherein the magnetron comprises magnets arranged in outer and inner rings, the outer ring magnets having North poles facing the electrode and sputtering target assembly and the inner ring having South poles facing the electrode and sputtering target assembly, wherein the outer ring extends about a periphery of the magnetron except in two radially opposed regions in which the radially opposed regions the outer ring diverges toward a central axis of the magnetron; and wherein the inner ring extends about the magnetron radially inside of the outer ring, the inner ring diverging toward a central axis of the magnetron in the two radially opposed regions.

9. The sputtering tool of claim 8 wherein the radially opposed regions are approximately sixty degrees in radial width.

10. The sputtering tool of either claim 8 or claim 9 wherein in a first radial region the distance of the outer ring from the central axis reduces by approximately one-fourth.

11. The sputtering tool of any one of claims 8 to 10 wherein in a second radial region the distance of the outer ring from the central axis reduces by approximately three-fourths.

12. The sputtering tool of claim 8 wherein in a first radial region the distance of the inner ring from the central axis reduces by approximately one third.

13. The sputtering tool of either claim 8 or claim 9 wherein in a second radial region the inner ring diverges substantially to the central axis.
